(19) Europäisches Patentamt
European Patent Office
Office européen des brevets

(11) **EP 4 145 221 A1**

(12) **EUROPEAN PATENT APPLICATION**
published in accordance with Art. 153(4) EPC

(43) Date of publication:
**08.03.2023 Bulletin 2023/10**

(21) Application number: **21795894.1**

(22) Date of filing: **28.04.2021**

(51) International Patent Classification (IPC):
**G03F 1/24** *(2012.01)*    **G03F 1/54** *(2012.01)*

(52) Cooperative Patent Classification (CPC):
**G03F 1/24; G03F 1/54**

(86) International application number:
**PCT/JP2021/017057**

(87) International publication number:
**WO 2021/221124 (04.11.2021 Gazette 2021/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.04.2020  JP 2020080520**

(71) Applicant: **Toppan Photomask Co., Ltd.
Tokyo 108-0023 (JP)**

(72) Inventors:
• **NAKANO, Hideaki**
  **Tokyo 110-0016 (JP)**
• **GODA, Ayumi**
  **Tokyo 110-0016 (JP)**
• **ICHIKAWA, Kenjiro**
  **Tokyo 110-0016 (JP)**

(74) Representative: **Hoffmann Eitle
Patent- und Rechtsanwälte PartmbB
Arabellastraße 30
81925 München (DE)**

(54) **REFLECTIVE PHOTOMASK BLANK AND REFLECTIVE PHOTOMASK**

(57)    The present invention is intended to provide a reflective photomask blank and a reflective photomask that suppress or reduce a shadowing effect of a reflective photomask for pattern transfer using light with a wavelength in an extreme ultraviolet region as a light source and that have hydrogen radical resistance. A reflective photomask blank (10) according to an embodiment of the present invention is a reflective photomask blank for producing a reflective photomask for pattern transfer using extreme ultraviolet light as a light source, and includes a substrate (1), a reflective layer (2) including a multi-layer film formed on the substrate (1), and an absorption layer (4) formed on the reflective layer (2). The absorption layer (4) is formed of a material containing a total of 50 atomic% or more of indium (In) and oxygen (O). An atomic number ratio (O/In) of oxygen (O) to indium (In) in the absorption layer (4) exceeds 1.5, and a film thickness of the absorption layer (4) is in a range of from 17 nm to 45 nm.

FIG. 1

EP 4 145 221 A1

**Description**

Technical Field

The present invention relates to a reflective photomask for use in lithography using light in an ultraviolet region as a light source and to a reflective photomask blank for producing the same.

Background Art

In manufacturing processes for semiconductor devices, a demand for finer photolithography technology is increasing along with miniaturization of semiconductor devices. The minimum resolution dimension of a transfer pattern in photolithography largely depends on the wavelength of an exposure light source, and the shorter the wavelength, the smaller the minimum resolution dimension can be. Therefore, exposure light sources have shifted from conventional ArF excimer laser light with a wavelength of 193 nm to light in an extreme ultraviolet (EUV) region with a wavelength of 13.5 nm.

Since light in the EUV region is absorbed by most substances at high rate, reflective photomasks are used as photomasks for EUV exposure (EUV photomasks) (see, for example, PTL 1). PTL 1 discloses an EUV photomask obtained by forming a reflective layer composed of a multi-layer film in which molybdenum (Mo) layers and silicon (Si) layers are alternately deposited on a glass substrate, forming a light absorption layer containing tantalum (Ta) as a main component on the reflective layer, and forming a pattern on the light absorption layer.

In addition, as described above, since EUV lithography cannot use a refractive optical system utilizing light transmission, the optical system member of an exposure apparatus is not a lens but a reflective (mirror). Due to this, there is a problem where incident light and reflected light on a reflective photomask (EUV mask) cannot be designed coaxially. Usually, EUV lithography employs a method in which light is incident with an optical axis inclined by 6 degrees from a vertical direction of the EUV mask, and reflected light reflected at an angle of minus 6 degrees is guided to a semiconductor substrate.

Thus, in EUV lithography, the optical axis is inclined through the mirror. This may cause a so-called "shadowing effect" problem where EUV light incident on the EUV mask creates a shadow of a mask pattern (patterned light absorption layer) of the EUV mask.

Current EUV mask blanks use a film containing tantalum (Ta) as a main component, which has a film thickness of from 60 to 90 nm, as a light absorption layer. When an EUV mask produced using such a mask blank is used to perform pattern transfer exposure, contrast reduction may occur at an edge portion in the shadow of a mask pattern depending on a relationship between an incident direction of EUV light and an orientation of the mask pattern. This may cause problems such as an increased line edge roughness of a transfer pattern on a semiconductor substrate and an inability to form a line width into a targeted dimension, which may deteriorate transfer performance.

Therefore, studies have been made on reflective photomask blanks in which in a light absorption layer, tantalum (Ta) is changed to a material having a high EUV absorption (extinction coefficient) or a material having a high EUV absorption is added to tantalum (Ta). For example, PTL 2 describes a reflective photomask blank including a light absorption layer formed of a material containing 50 atomic% (at%) or more of Ta as a main component and further containing at least one element selected from Te, Sb, Pt, I, Bi, Ir, Os, W, Re, Sn, In, Po, Fe, Au, Hg, Ga, and Al.

Additionally, the mirror is known to be contaminated by by-products (for example, Sn), carbon, and the like produced by EUV. Accumulation of contaminants on the mirror reduces the reflectance of a mirror surface, lowering throughput of a lithographic apparatus. To solve this problem, PTL 3 discloses a method for removing a contaminant from a mirror by generating a hydrogen radical in an apparatus and causing the hydrogen radical to react with the contaminant.

However, in the reflective photomask blank described in PTL 2, the resistance of the light absorption layer to hydrogen radicals (hydrogen radical resistance) has not been considered. Therefore, a transfer pattern (mask pattern) formed on the light absorption layer by introduction into an EUV exposure apparatus cannot be maintained stably, which may result in deteriorated transferability.

Citation List

Patent Literature

PTL 1: JP 2011-176162 A
PTL 2: JP 2007-273678 A

PTL 3: JP 2011-530823 A

Summary of Invention

Technical Problem

Accordingly, it is an object of the present invention to provide a reflective photomask blank and a reflective photomask that suppress or reduce the shadowing effect of a reflective photomask for pattern transfer using light with a wavelength in the extreme ultraviolet region as a light source and that have hydrogen radical resistance.

Solution to Problem

In order to achieve the above object, a reflective photomask blank according to one aspect of the present invention is a reflective photomask blank for producing a reflective photomask for pattern transfer using extreme ultraviolet light as a light source, the reflective photomask blank including a substrate, a reflective layer including a multi-layer film formed on the substrate, and an absorption layer formed on the reflective layer, wherein the absorption layer is formed of a material containing a total of 50 atomic% or more of indium (In) and oxygen (O), an atomic number ratio (O/In) of oxygen (O) to indium (In) in the absorption layer exceeding 1.5, and a film thickness of the absorption layer is in a range of from 17 nm to 45 nm.

Additionally, a reflective photomask according to one aspect of the present invention includes a substrate, a reflective layer including a multi-layer film formed on the substrate, and an absorption pattern layer formed on the reflective layer and including a material containing a total of 50 atomic% or more of indium (In) and oxygen (O) and having an atomic number ratio (O/In) of oxygen (O) to indium (In) exceeding 1.5, the absorption pattern layer being formed with a pattern, wherein a film thickness of the absorption pattern layer is in a range of from 17 nm to 45 nm.

Advantageous Effects of Invention

According to the one aspect of the present invention, a reflective photomask can be expected that exhibits improved transfer performance on a semiconductor substrate in patterning using light with a wavelength in the extreme ultraviolet region as a light source and that can be used even in hydrogen radical environments. In other words, the reflective photomask blank and the reflective photomask according to the aspects of the present invention suppress or reduce shadowing effects of reflective photomasks for pattern transfer using light with a wavelength in the extreme ultraviolet region as a light source, and have hydrogen radical resistance.

Brief Description of Drawings

FIG. 1 is a schematic cross-sectional diagram illustrating the structure of a reflective photomask blank according to an embodiment of the present invention;
FIG. 2 is a schematic cross-sectional diagram illustrating the structure of a reflective photomask according to an embodiment of the present invention;
FIG. 3 is a graph illustrating optical constants of each metal material at a wavelength of EUV light;
FIG. 4 is a schematic cross-sectional diagram illustrating the structure of a reflective photomask blank according to Example of the present invention;
FIG. 5 is a schematic cross-sectional diagram illustrating a step of manufacturing a reflective photomask according to the Example of the present invention;
FIG. 6 is a schematic cross-sectional diagram illustrating a step of manufacturing the reflective photomask according to the Example of the present invention;
FIG. 7 is a schematic cross-sectional diagram illustrating a step of manufacturing the reflective photomask according to the Example of the present invention;
FIG. 8 is a schematic cross-sectional diagram illustrating the structure of the reflective photomask according to the Example of the present invention;
FIG. 9 is a schematic plan view illustrating the shape of a design pattern of the reflective photomask according to the Example of the present invention; and
FIG. 10 is a graph illustrating reflectances of reflective photomasks according to Examples and Comparative Examples of the present invention.

Description of Embodiments

Hereinafter, embodiments of the present invention are described with reference to the drawings. However, the present invention is not limited to the embodiments below. Although the embodiments given below describe technologically preferable limitations in order to carry out the present invention, such limitations are not essential requirements of the present invention.

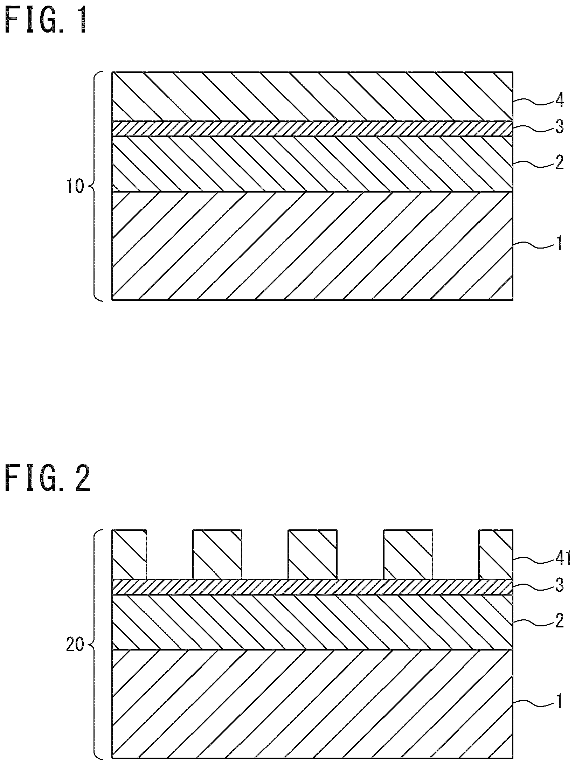

FIG. 1 is a schematic cross-sectional diagram illustrating the structure of a reflective photomask blank 10 according to an embodiment of the present invention. Additionally, FIG. 2 is a schematic cross-sectional diagram illustrating the structure of a reflective photomask 20 according to an embodiment of the present invention. Here, the reflective photomask 20 according to the embodiment of the present invention illustrated in FIG. 2 is formed by patterning an absorption layer 4 of the reflective photomask blank 10 according to the embodiment of the present invention illustrated in FIG. 1.

(Overall structure)

As illustrated in FIG. 1, the reflective photomask blank 10 according to the embodiment of the present invention includes a substrate 1, a reflective layer 2 formed on the substrate 1, a capping layer 3 formed on the reflective layer 2, and the absorption layer 4 formed on the capping layer 3.

(Substrate)

As the substrate 1 according to the embodiment of the present invention, for example, a flat substrate made of silicon, synthetic quartz, or the like can be used. Alternatively, low thermal expansion glass containing titanium can be used for the substrate 1. However, the present invention is not limited to these materials as long as they have a low thermal expansion coefficient.

(Reflective layer)

The reflective layer 2 according to the embodiment of the present invention can be any one that reflects EUV light (extreme ultraviolet light) that is exposure light, and may be a multi-layer reflective film made of a combination of materials having significantly different refractive indices for EUV light. The reflective layer 2 including the multi-layer reflective film may be formed, for example, by repeatedly depositing a layer of a combination of molybdenum (Mo) and silicon (Si) or molybdenum (Mo) and beryllium (Be) for about 40 cycles.

(Capping layer)

The capping layer 3 according to the embodiment of the present invention is formed of a material having resistance to dry etching performed when forming a transfer pattern (mask pattern) on the absorption layer 4, and functions as an etching stopper preventing damage to the reflective layer 2 when etching the absorption layer 4. The capping layer 3 is formed of, for example, ruthenium (Ru). Here, depending on the material of the reflective layer 2 and etching conditions, the capping layer 3 may not be formed. Additionally, although not illustrated, a backside conductive film can be formed on a surface of the substrate 1 not having the reflective layer 2. The backside conductive film is a film for fixing the reflective photomask 20 by utilizing an electrostatic chuck principle when it is installed in an exposure apparatus.

(Absorption layer)

As illustrated in FIG. 2, an absorption pattern (absorption pattern layer) 41 of the reflective photomask 20 is formed by removing a part of the absorption layer 4 of the reflective photomask blank 10, i.e., by patterning the absorption layer 4. In EUV lithography, EUV light enters at an angle, and is reflected by the reflective layer 2. However, due to a shadowing effect in which the absorption pattern 41 obstructs a light path, transfer performance onto a wafer (semiconductor substrate) may be deteriorated. The deterioration in the transfer performance is reduced by reducing the thickness of the absorption layer 4 absorbing EUV light. In order to reduce the thickness of the absorption layer 4, it is preferable to apply a material that has higher EUV light absorption than the conventional material, i.e., a material that has a high extinction coefficient k at the wavelength of 13.5 nm.

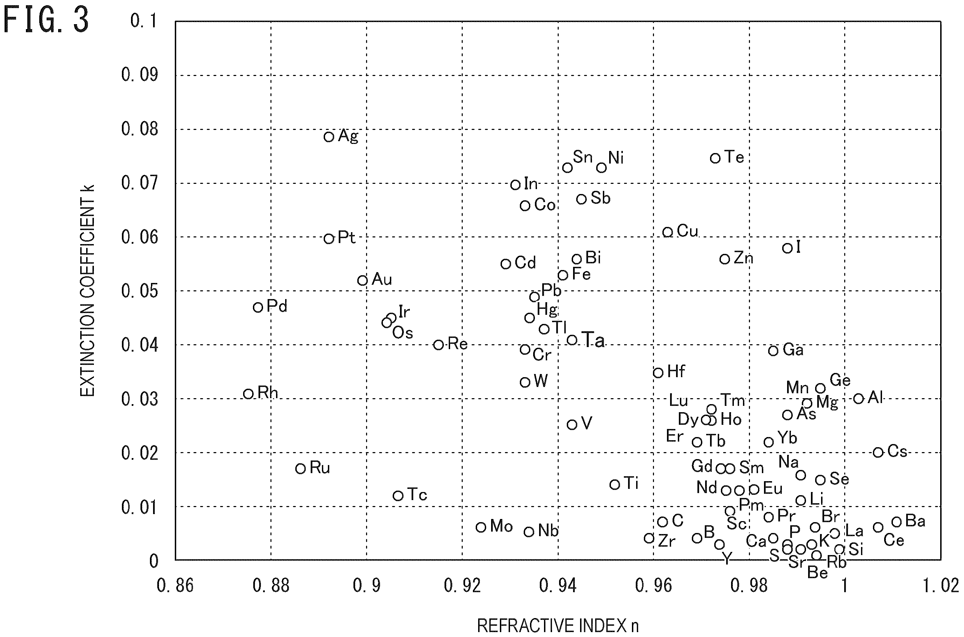

FIG. 3 is a graph illustrating optical constants of each metal material at the wavelength of EUV light of 13.5 nm. The horizontal axis of FIG. 3 represents a refractive index n, and the vertical axis thereof represents the extinction coefficient k. The extinction coefficient k of tantalum (Ta), which is the main material of the conventional absorption layer 4, is 0.041. Using a compound material having an extinction coefficient k higher than that can reduce the thickness of the absorption layer 4 as compared with the conventional one. When the extinction coefficient k is equal to or higher than 0.06, the thickness of the absorption layer 4 can be sufficiently reduced, allowing for reduction of the shadowing effect.

Examples of a material that satisfies a combination of optical constants (nk values) as described above include silver (Ag), platinum (Pt), indium (In), cobalt (Co), tin (Sn), nickel (Ni), and tellurium (Te), as illustrated in FIG. 3.

Additionally, since the reflective photomask 20 is exposed to a hydrogen radical environment, the reflective photomask 20 cannot withstand long-term use unless the material is a light absorbing material highly resistant to hydrogen radicals. In the embodiment of the present invention, materials having a film reduction rate of 0.1 nm/s or less in a hydrogen radical environment using microwave plasma at a power of 1 kW under a hydrogen pressure of 0.36 millibar (mbar) or less are considered to be highly resistant to hydrogen radicals.

Among the above-mentioned materials, indium (In) by itself is known to be less resistant to hydrogen radicals, but the addition of oxygen increases resistance thereto. Specifically, as illustrated in Table 1, hydrogen radical resistance was confirmed in materials having an atomic number ratio of indium (In) to oxygen (O) exceeding 1:1.5. This is thought to be because when the atomic number ratio of indium (In) to oxygen (O) is less than 1:1.5, bonds of indium (In) do not all become indium oxide ($In_2O_3$), and an atomic number ratio exceeding 1:1.5 is required to make the entire film (the entire absorption layer 4) indium oxide ($In_2O_3$) - Additionally, in an evaluation test of film reduction rate illustrated in Table 1, the film reduction rate was repeatedly measured a plurality of times, in which when all the measurements had a film reduction rate of 0.1 nm/s or less, it was evaluated as "o", when although there was a film reduction of a few nm immediately after the start of hydrogen radical treatment, the film reduction rate thereafter was 0.1 nm/s or less, it was evaluated as "Δ", and when the film reduction rate exceeded 0.1 nm/s in all the measurements, it was evaluated as "x". In the embodiment of the present invention, the evaluation of "Δ" indicates that there is no problem in use, but more preferred is the evaluation of "o".

In addition, the above atomic number ratio (O/In ratio) is a result of measurement of a material formed into a film thickness of 1 μm through energy dispersive X-ray analysis (EDX).

Table 1

| O/In ratio | 1.0 | 1.5 | 2.0 | 2.5 |
|---|---|---|---|---|
| Hydrogen radical resistance | × | Δ | ○ | ○ |

The material containing indium (In) and oxygen (O) for forming the absorption layer 4 preferably contains more oxygen (O) than indium oxide ($In_2O_3$) having a stoichiometric composition. Specifically, the atomic number ratio of indium (In) to oxygen (O) in the material that constitutes the absorption layer 4 preferably exceeds 1:1.5. In other words, in the absorption layer 4, the atomic number ratio (O/In) of oxygen (O) to indium (In) preferably exceeds 1.5. When the atomic number ratio of indium (In) to oxygen (O) in the material constituting the absorption layer 4 exceeds 1:1.5, sufficient hydrogen radical resistance can be given to the absorption layer 4.

Additionally, when the atomic number ratio of indium (In) to oxygen (O) exceeds 1:2.5, EUV light absorbance progressively decreases. Therefore, the atomic number ratio is preferably equal to or less than 1:3, and more preferably equal to or less than 1:2.5.

Additionally, the material constituting the absorption layer 4 preferably contains a total of 50 atomic% or more of indium (In) and oxygen (O) . This is because when the absorption layer 4 contains components other than indium (In) and oxygen (O), both EUV light absorbance and hydrogen radical resistance may decrease, but when the amount of the components other than indium (In) and oxygen (O) is less than 50 atomic%, the EUV light absorbance and the hydrogen radical resistance slightly decrease, and the performance of the EUV mask as the absorption layer 4 is hardly deteriorated.

Examples of materials other than indium (In) and oxygen (O) that may be mixed include Ta, Pt, Te, Zr, Hf, Ti, W, Si, Cr, Mo, Sn, Pd, Ni, F, N, C, and H. In other words, the absorption layer 4 may further contain one or more elements selected from a group consisting of Ta, Pt, Te, Zr, Hf, Ti, W, Si, Cr, Mo, Sn, Pd, Ni, F, N, C, and H.

For example, mixing at least one of Ta, Pt, Te, Sn, Pd, or Ni in the absorption layer 4 can make the film (absorption layer 4) conductive while ensuring high absorption of EUV light. This can improve inspectability in mask pattern inspections using deep ultraviolet (DUV) light with a wavelength of from 190 to 260 nm. Alternatively, when mixing at least one of N, Hf, Zr, Mo, Cr, or F in the absorption layer 4, it is possible to make quality of the film more amorphous. This can improve roughness and in-plane dimensional uniformity of an absorption layer pattern (mask pattern) after dry etching or in-plane uniformity of a transferred image. Alternatively, mixing at least one of Ti, W, or Si in the absorption layer 4 can improve resistance to cleaning. Here, the above-mentioned "amorphous" means that the entire absorption layer 4 is in a non-crystalline (amorphous) form or that the entire absorption layer 4 is in a non-crystalline (amorphous) form including a microcrystalline portion (crystalline). Furthermore, the above-mentioned "amorphous" also includes a form generally called "quasi-amorphous".

Note that although FIGS. 1 and 2 illustrate the absorption layer 4 as a single layer, the absorption layer 4 according to the embodiment of the present invention is not limited thereto. The absorption layer 4 according to the embodiment of the present invention may be, for example, one or more absorption layers, i.e., a multi-layer absorption layer.

As described above, a compound material containing Ta as the main component has been applied to the absorption layer 4 of the conventional EUV reflective photomasks. In this case, to obtain an optical density OD (Equation 1), which is an index indicating a contrast in light intensity between the absorption layer 4 and the reflective layer 2, equal to or more than 1, the film thickness of the absorption layer 4 has needed to be 40 nm or more, and to obtain an OD of 2 or more, the film thickness of the absorption layer 4 has needed to be 70 nm or more. Although the extinction coefficient k of Ta is 0.041, applying a compound material containing indium (In) having an extinction coefficient k of 0.06 or more and oxygen (O) to the absorption layer 4 can reduce the film thickness of the absorption layer 4 to 17 nm when the OD is at least 1 or more, and to 45 nm or less when the OD is 2 or more, according to Beer's law. However, when the film thickness of the absorption layer 4 exceeds 45 nm, the shadowing effect is similar to that of the conventional absorption layer 4 having a film thickness of 60 nm formed of a compound material containing Ta as the main component.

$$OD = -\log(Ra/Rm) \; \ldots \; (Equation\ 1)$$

Note that the above "Ra" means a reflectance in the absorption layer 4, and the above "Rm" means a reflectance of the reflective layer 2 or of the reflective layer 2 and the capping layer 3.

Therefore, the film thickness of the absorption layer 4 according to the embodiment of the present invention is preferably from 17 nm to 45 nm. In other words, when the film thickness of the absorption layer 4 is in the range of from 17 nm to 45 nm, the shadowing effect can be sufficiently reduced as compared with the conventional absorption layer 4 formed of a compound material containing Ta as a main component, thus improving transfer performance. In addition, the optical density (OD: Optical Density) value is the contrast between the absorption layer 4 and the reflective layer 2. When the OD value is less than 1, sufficient contrast cannot be obtained, so that transfer performance tends to de deteriorated.

Furthermore, the above-mentioned "main component" means a component that contains 50 atomic% or more of the number of atoms in the entire absorption layer.

Hereinafter, a description is given of Examples of the reflective photomask blank and the reflective photomask according to the present invention.

Example 1

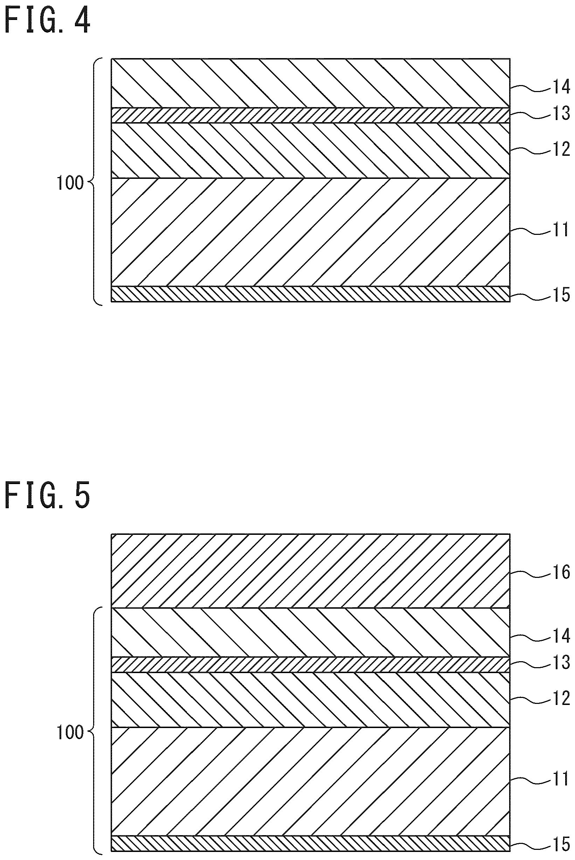

First, a method for producing a reflective photomask blank 100 is described with reference to FIG. 4.

First, as illustrated in FIG. 4, a reflective layer 12 formed by depositing 40 deposited films each including a pair of silicon (Si) and molybdenum (Mo) is formed on a synthetic quartz substrate 11 having low thermal expansion characteristics. The reflective layer 12 had a film thickness of 280 nm.

Next, a capping layer 13 formed of ruthenium (Ru) as an intermediate film was formed on the reflective layer 12 so as to have a film thickness of 3.5 nm.

Then, an absorption layer 14 containing indium (In) and oxygen (O) was formed on the capping layer 13 so as to have a film thickness of 26 nm. The atomic number ratio of indium (In) to oxygen (O) was 1:2 as measured by an energy dispersive X-ray analysis (EDX). Additionally, crystallinity of the absorption layer 14 was measured by an X-ray diffractometer (XRD) and found to be amorphous, although crystallinity was slightly observed.

Next, a backside conductive film 15 formed of chromium nitride (CrN) was formed with a thickness of 100 nm on a surface on a side of the substrate 11 not having the reflective layer 12 to produce the reflective photomask blank 100.

The formation of each film (layer formation) on the substrate 11 was performed using a multi-source sputtering apparatus. The film thickness of each film was controlled by sputtering time. The absorption layer 14 was formed by a reactive sputtering process so as to obtain an O/In ratio of 2 by controlling the amount of oxygen introduced into the chamber during sputtering.

Next, a method for producing a reflective photomask 200 is described with reference to FIGS. 5 to 8.

First, as illustrated in FIG. 5, a chemically amplified positive resist (SEBP 9012: manufactured by Shin-Etsu Chemical Co., Ltd.) was applied onto the absorption layer 14 of the reflective photomask blank 100 by spin coating to a film thickness of 120 nm, and baking was performed at 110°C for 10 minutes to form a resist film 16.

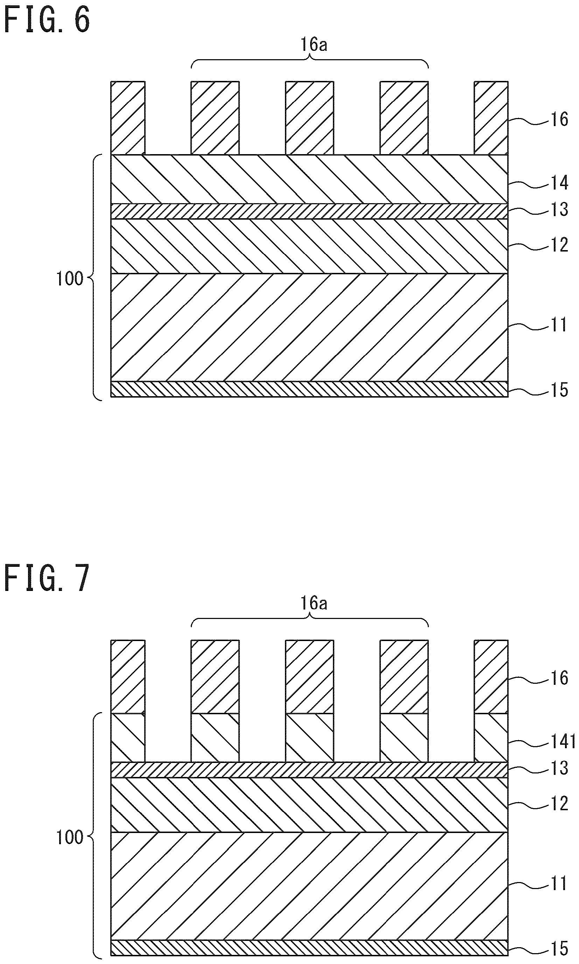

Then, a predetermined pattern was drawn on the resist film 16 by an electron beam lithography system (JBX 3030: manufactured by JEOL Ltd). After that, prebaking treatment was performed at 110°C for 10 minutes, followed by development treatment using a spray developer (SFG 3000: manufactured by Sigma Meltec Ltd). As a result, a resist pattern 16a was formed, as illustrated in FIG. 6.

Next, using the resist pattern 16a as an etching mask, the absorption layer 14 was patterned by dry etching mainly using a chlorine-based gas. As a result, an absorption pattern (absorption pattern layer) 141 was formed in the absorption layer 14, as illustrated in FIG. 7.

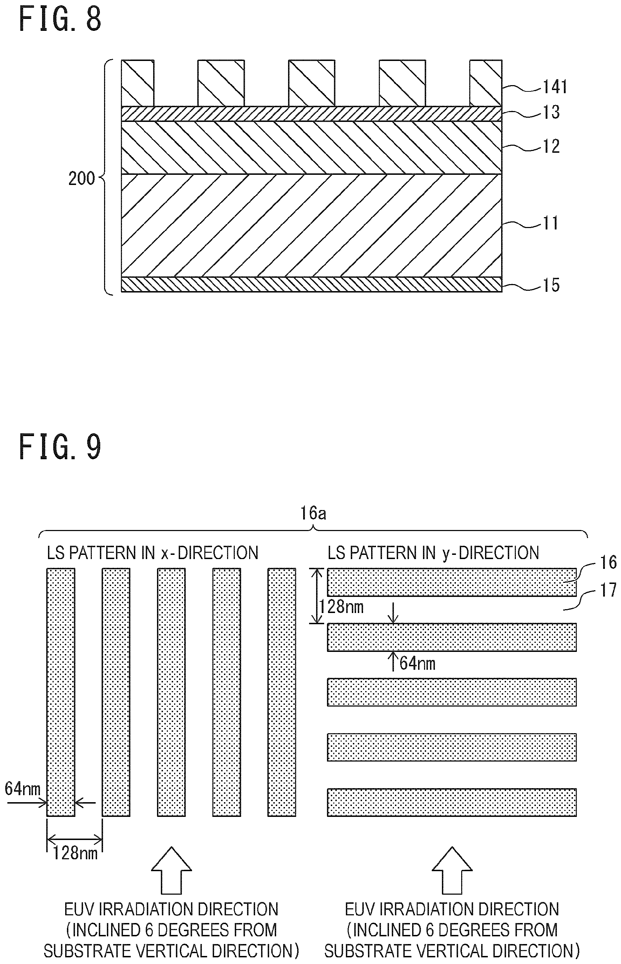

Then, the resist pattern 16a was peeled off to produce the reflective photomask 200 of the present Example, as illustrated in FIG. 8. In the present Example, the absorption pattern 141 formed in the absorption layer 14 includes a line width 64 nm LS (line and space) pattern, a line width 200 nm LS pattern for measuring the film thickness of the absorption layer using AFM, and a 4 mm square absorption layer removing portion for measuring EUV reflectance on the reflective photomask 200 for transfer evaluation. In the present Example, the line width 64 nm LS pattern was designed in each of an x-direction and a y-direction, as illustrated in FIG. 9, so that influence of the shadowing effect caused by EUV irradiation were easily visible.

Example 2

The absorption layer 14 was formed so that the atomic number ratio of indium (In) to oxygen (O) in the absorption layer 14 was 1:2, a total content of indium (In) and oxygen (O) was 70 atomic% of the entire absorption layer 14, and the remaining 30 atomic% was Ta. Additionally, the absorption layer 14 was formed so as to have a film thickness of 26 nm. Additionally, the reflective photomask blank 100 and the reflective photomask 200 of Example 2 were produced in the same manner as in Example 1 except for the film formation of the absorption layer 14.

Example 3

The absorption layer 14 was formed so that the atomic number ratio of indium (In) to oxygen (O) in the absorption layer 14 was 1:2, the total content of indium (In) and oxygen (O) was 70 atomic% of the entire absorption layer 14, and the remaining 30 atomic% was Sn. Additionally, the absorption layer 14 was formed so as to have a film thickness of 26 nm. Additionally, the reflective photomask blank 100 and the reflective photomask 200 of Example 3 were produced in the same manner as in Example 1 except for the film formation of the absorption layer 14.

Comparative Example 1

The absorption layer 14 was formed so that the atomic number ratio of indium (In) to oxygen (O) in the absorption layer 14 was 1:1, and the film thickness of the absorption layer 14 was 26 nm. Additionally, the reflective photomask blank 100 and the reflective photomask 200 of Comparative Example 1 were produced in the same manner as in Example 1 except for the film formation of the absorption layer 14.

Comparative Example 2

The absorption layer 14 was formed so that the atomic number ratio of indium (In) to oxygen (O) in the absorption layer 14 was 1:2, and the film thickness of the absorption layer 14 was 15 nm. Additionally, the reflective photomask blank 100 and the reflective photomask 200 of Comparative Example 2 were produced in the same manner as in Example 1 except for the film formation of the absorption layer 14.

Comparative Example 3

The absorption layer 14 was formed so that the atomic number ratio of indium (In) to oxygen (O) in the absorption layer 14 was 1:2, the total content of indium (In) and oxygen (O) was 30 atomic% of the entire absorption layer 14, and the remaining 70 atomic% was SiO. Additionally, the absorption layer 14 was formed so as to have a film thickness of 26 nm. In addition, the reflective photomask blank 100 and the reflective photomask 200 of Comparative Example 3 were produced in the same manner as in Example 1 except for the film formation of the absorption layer 14.

Apart from the above-described Examples and Comparative Examples, a reflective photomask including a conventional tantalum (Ta)-based absorption layer was also compared as Reference Example. As in the above-described Examples and Comparative Examples, a reflective photomask blank includes a reflective layer formed by depositing 40 deposited films each including a pair of silicon (Si) and molybdenum (Mo) and a ruthenium (Ru) capping layer 3 having a film thickness of 3.5 nm on a synthetic quartz substrate having low thermal expansion characteristics. The absorption layer 14 formed on the capping layer 3 was obtained by forming a TaO film having a film thickness of 2 nm on a TaN film having a film thickness of 58 nm. Additionally, as in the above-described Examples and Comparative Examples, the reflective photomask with the absorption layer 14 patterned was used for evaluation.

In the above-described Examples and Comparative Examples, the film thickness of the absorption layer 14 was measured through a transmission electron microscope.

Evaluation items evaluated in the present Example are described hereinbelow.

(Reflectance)

In the above-described Examples and Comparative Examples, a reflectance Ra of the absorption pattern layer 141 region of the produced reflective photomask 200 was measured by a reflectance measuring apparatus using EUV light. In this way, OD values of the reflective photomasks 200 according Examples and Comparative Examples were obtained.

(Hydrogen radical resistance)

Using microwave plasma, the reflective photomasks 200 produced by Examples and Comparative Examples were placed in a hydrogen radical environment with a hydrogen pressure of 0.36 millibar (mbar) or less at a power of 1 kW. A change in the film thickness of the absorption layer 14 (absorption pattern layer 141) after the hydrogen radical treatment was confirmed using an atomic force microscope (AFM). The measurement was performed on the line width 200 nm LS pattern.

(Wafer exposure evaluation)

Using an EUV exposure system (NXE 3300B: manufactured by ASML Co., Ltd.), the absorption pattern 141 of each of the reflective photomasks 200 produced in Examples and Comparative Examples was transferred and exposed on a semiconductor wafer coated with a chemically amplified EUV positive resist. At this time, the amount of exposure was adjusted so that the LS pattern in the x-direction illustrated in FIG. 9 was transferred as designed. Specifically, in the present exposure test, the LS pattern (line width 64 nm) in the x-direction illustrated in FIG. 9 was exposed so that the line width was 16 nm on the semiconductor wafer. Observation and line width measurement of the transferred resist pattern were performed by an electron beam dimension measuring apparatus to confirm resolution.

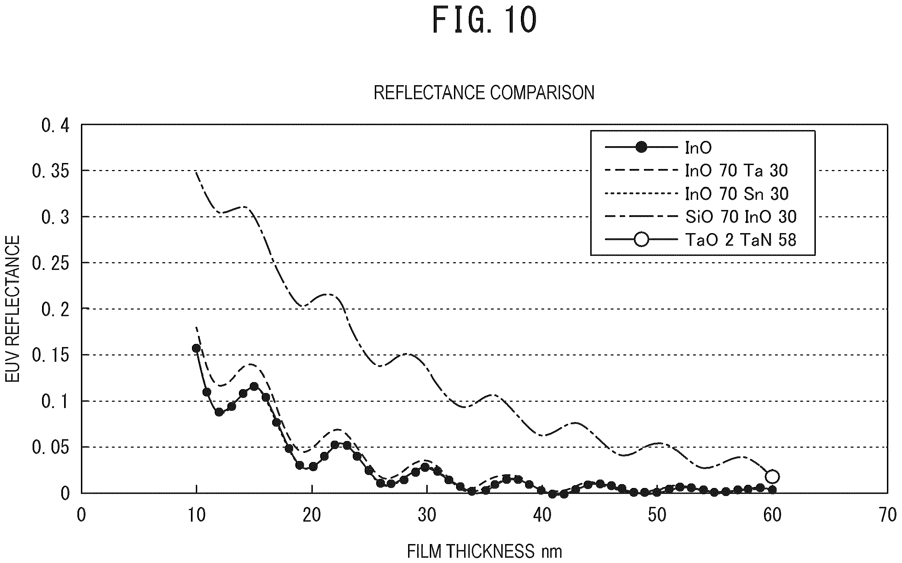

FIG. 10 and Tables 2 and 3 depict the results of these evaluations.

Table 2

|  | Composition | Hydrogen radical resistance |
|---|---|---|
| Ex.1 | In+O(1:2) | ○ |
| Ex. 2 | In+O(1:2) 70% Ta 30% | ○ |
| Ex. 3 | In+O(1:2) 70% Sn 30% | ○ |
| Comp. Ex.1 | In+O(1:1) | × |
| Comp. Ex.2 | In+O(1:2) | ○ |
| Comp. Ex.3 | SiO 70% In+0(1:2) 30% | × |
| Ref. Ex. | TaO 2 nm TaN 58 nm | ○ |

Table 3

|  | Composition | n | k | Film thickness | x-direction dimension (nm) | y-direction dimension (nm) | OD value | Determination |
|---|---|---|---|---|---|---|---|---|
| Ex.1 | In+O(1:2) | 0.92 | 0.07 | 26 | 16 | 11.8 | 1.77 | ○ |
| Ex. 2 | In+O(1:2) 70% Ta30% | 0.93 | 0.06 | 26 | 16 | 12.4 | 1.55 | ○ |

(continued)

|  | Composition | n | k | Film thickness | x-direction dimension (nm) | y-direction dimension (nm) | OD value | Determination |
|---|---|---|---|---|---|---|---|---|
| Ex. 3 | In+O(1:2) 70% Sn30% | 0.92 | 0.07 | 26 | 16 | 11.8 | 1.76 1.77 | ○ |
| Comp. Ex.1 | In+O (1: 1) | 0.92 | 0.07 | 26 | 16 | 11.8 | | ○ |
| Comp. Ex. 2 | In+O(1:2) | 0.92 | 0.07 | 15 | 16 | 14.0 | 0.74 | × |
| Comp. Ex.3 | SiO 70% In+0(1:2) 30% | 0.96 | 0.03 | 26 | 16 | 14.7 | 0.66 | × |
| Ref. Ex. | TaO 2 nm TaN 58 nm | - | - | 60 | 16 | 8.7 | 1.54 | ○ |

FIG. 10 depicts EUV light reflectances of each Example and each Comparative Example. In FIG. 10, the reflective photomasks 200 including the absorption layers 14 with the atomic number ratios of indium (In) to oxygen (O) of 1:1 and 1:2, i.e., the absorption layers 14 (absorption pattern layers 141) of Example 1 and Comparative Examples 1 and 2 are depicted collectively since they had no change in the reflectance.

As depicted in FIG. 10 and Table 3, the reflectance of the reflective photomask 200 including the conventional tantalum (Ta)-based absorption layer having the film thickness of 60 nm was 0.019 (OD = 1.54), whereas the reflectance of the reflective photomasks 200 including the absorption layer 14 having the film thickness of 26 nm and formed of a material containing In and O, i.e., the absorption layers 14 (absorption pattern layers 141) of Example 1 and Comparative Example 1 was 0.011 (OD = 1.77), the reflectance of the reflective photomask 200 including the absorption layer 14 formed of a material containing 30 atomic% of Ta, i.e., the absorption layer 14 (absorption pattern layer 141) of the Example 2 was 0.018 (OD = 1.55), and the reflectance of the reflective photomask 200 including the absorption layer 14 formed of a material containing 30 atomic% of Sn, i.e., the absorption layer 14 (absorption pattern layer 141) of Example 3 was 0.011 (OD = 1.76), which were favorable.

On the contrary, the reflective photomask 200 including the absorption layer 14 formed of an In and O-containing material and having the film thickness of 15 nm, i.e., the absorption layer 14 (absorption pattern layer 141) of Comparative Example 2 had a reflectance of 0.116 (OD = 0.74), and transfer performance was deteriorated. Furthermore, the reflective photomask 200 including the absorption layer 14 formed of a material in which the total content of In and O was 30 atomic% of the entire absorption layer 14 and the remaining 70 atomic% was SiO, i.e., the absorption layer 14 (absorption pattern layer 141) of Comparative Example 3 had a reflectance of 0.139 (OD = 0.66), resulting in deteriorated transfer performance.

In addition, the present evaluation considered an OD value of 1 or greater to be no problem for transfer performance and determined as "PASS".

Table 2 depicts the results of hydrogen radical resistance of the reflective photomasks 200 according to each Example and each Comparative Example. In Table 2, "o" represents materials having a film reduction rate of the absorption layer 14 (absorption pattern layer 141) of 0.1 nm/s or less, and "x" represents materials having a film reduction rate thereof exceeding 0.1 nm/s. The absorption layers 14 containing 70 atomic% or more of a material having the atomic number ratio of indium (In) to oxygen (O) of 1:2, i.e., the absorption layers 14 of Examples 1 to 3 and Comparative Example 2 were confirmed to have favorable hydrogen radical resistance. However, in the cases of the absorption layer 14 formed of a material having the atomic number ratio of In to O of 1:1, i.e., the absorption layer 14 of Comparative Example 1, and the absorption layer 14 formed of a material in which although the atomic number ratio of In to O was 1:2, the total content of In and O was 30 atomic% of the entire absorption layer 14, i.e., the absorption layer 14 of Comparative Example 3, sufficient hydrogen radical resistance was not obtainable.

Table 3 depicts mask characteristics of the reflective photomasks 200 according to each Example and each Comparative Example and resist pattern dimensions on the wafer.

In the reflective photomasks 200 including the absorption layer 14 having the film thickness of 26 nm and formed of an In and O-containing material, i.e., the absorption layers 14 (absorption pattern layers 141) of Example 1 and Comparative Example 1, the reflective photomask 200 including the absorption layer 14 formed of a material containing 30 atomic% of Ta, i.e., the absorption layer 14 (absorption pattern layer 141) of Example 2, and the reflective photomask 200 including the absorption layer 14 formed of a material containing 30 atomic% of Sn, i.e., the absorption layer 14 (absorption pattern layer 141) of Example 3, the pattern dimensions in the y-direction were more favorable than the pattern dimension in the y-direction of 8.7 nm using the conventional Ta-based absorption layer, and were 11.8 nm, 12.4 nm, and 11.8 nm, respectively.

In the reflective photomask 200 including the absorption layer 14 having the film thickness of 15 nm and formed of an In and O-containing material, i.e., the absorption layer 14 (absorption pattern layer 141) of Comparative Example 2 and the reflective photomask 200 including the absorption layer 14 formed of a material in which the total content of In and O was 30 atomic% of the entire absorption layer 14, i.e., the absorption layer 14 (absorption pattern layer 141) of Comparative Example 3, the pattern dimensions in the y-direction were 14.0 nm and 14.7 nm, which were even more favorable, but at least one of the reflectance or the hydrogen radical resistance was insufficient, as described above.

Note that, in Table 3, the reflective photomasks 200 that were able to suppress or reduce the shadowing effect were marked with "o" in the column of "Determination", and the reflective photomasks 200 that were not able to sufficiently suppress or reduce the shadowing effect were marked with "x" in the column of "Determination".

As a result, it is shown that when the photomask includes the absorption layer 14 formed of an indium (In) and oxygen (O)-containing material that contains more oxygen than indium oxide having a stoichiometric composition, both favorable optical density and hydrogen radical resistance are favorable, the shadowing effect can be reduced, the life is longer, and the transfer performance improves.

Industrial Applicability

The reflective photomask blank and the reflective photomask according to the present invention can be suitably used to form a fine pattern by EUV exposure in a process for manufacturing a semiconductor integrated circuit or the like.

Reference Signs List

1: Substrate
2: Reflective layer
3: Capping layer
4: Absorption layer
41: Absorption pattern (absorption pattern layer)
10: Reflective photomask blank
20: Reflective photomask
11: Substrate
12: Reflective layer
13: Capping layer
14: Absorption layer
141: Absorption pattern (absorption pattern layer)
15: Backside conductive film
16: Resist film
16a: Resist pattern
17: Reflective portion
100: Reflective photomask blank
200: Reflective photomask

**Claims**

1. A reflective photomask blank for producing a reflective photomask for pattern transfer using extreme ultraviolet light as a light source, the reflective photomask blank comprising:

   a substrate;
   a reflective layer including a multi-layer film formed on the substrate; and
   an absorption layer formed on the reflective layer,
   wherein
   the absorption layer is formed of a material containing a total of 50 atomic% or more of indium (In) and oxygen (O), an atomic number ratio (O/In) of oxygen (O) to indium (In) in the absorption layer exceeding 1.5, and a film thickness of the absorption layer is in a range of from 17 nm to 45 nm.

2. The reflective photomask blank according to claim 1, wherein the absorption layer further contains one or more elements selected from a group consisting of Ta, Pt, Te, Zr, Hf, Ti, W, Si, Cr, Mo, Sn, Pd, Ni, F, N, C, and H.

3. A reflective photomask comprising:

   a substrate;
   a reflective layer including a multi-layer film formed on the substrate; and
   an absorption pattern layer formed on the reflective layer and including a material containing a total of 50 atomic% or more of indium (In) and oxygen (O) and having an atomic number ratio (O/In) of oxygen (O) to indium (In) exceeding 1.5, the absorption pattern layer being formed with a pattern,
   wherein a film thickness of the absorption pattern layer is in a range of from 17 nm to 45 nm.

4. The reflective photomask according to claim 3, wherein
   the absorption pattern layer further contains one or more elements selected from a group consisting of Ta, Pt, Te, Zr, Hf, Ti, W, Si, Cr, Mo, Sn, Pd, Ni, F, N, C, and H.

FIG. 1

FIG. 2

FIG. 3

# FIG. 4

# FIG. 5

FIG. 6

16a

100

16

14

13

12

11

15

FIG. 7

16a

100

16

141

13

12

11

15

# FIG. 8

# FIG. 9

16a

LS PATTERN IN x-DIRECTION    LS PATTERN IN y-DIRECTION

16
17

128nm

64nm

64nm

128nm

EUV IRRADIATION DIRECTION
(INCLINED 6 DEGREES FROM
SUBSTRATE VERTICAL DIRECTION)

EUV IRRADIATION DIRECTION
(INCLINED 6 DEGREES FROM
SUBSTRATE VERTICAL DIRECTION)

# FIG. 10

REFLECTANCE COMPARISON

EP 4 145 221 A1

# EP 4 145 221 A1

<div align="center">

## INTERNATIONAL SEARCH REPORT

</div>

| | International application No. |
|---|---|
| | **PCT/JP2021/017057** |

**A. CLASSIFICATION OF SUBJECT MATTER**

*G03F 1/24*(2012.01)i; *G03F 1/54*(2012.01)i
FI:   G03F1/24; G03F1/54

According to International Patent Classification (IPC) or to both national classification and IPC

**B. FIELDS SEARCHED**

Minimum documentation searched (classification system followed by classification symbols)

G03F1/24; G03F1/54

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2019-139085 A (TOPPAN PRINTING CO., LTD.) 22 August 2019 (2019-08-22) claims 1-4, paragraphs [0020]-[0070], fig. 1-11 | 1-4 |
| A | JP 2010-103463 A (TOPPAN PRINTING CO., LTD.) 06 May 2010 (2010-05-06) paragraphs [0037]-[0115], fig. 1-15 | 1-4 |
| A | JP 2009-519593 A (COMMISSARIAT ENERGIE ATOMIQUE) 14 May 2009 (2009-05-14) claim 1, paragraphs [0018]-[0038], fig. 1-3 | 1-4 |
| A | JP 2008-41740 A (TOPPAN PRINTING CO., LTD.) 21 February 2008 (2008-02-21) paragraphs [0041]-[0047], fig. 1-2 | 1-4 |
| A | JP 2006-190900 A (TOPPAN PRINTING CO., LTD.) 20 July 2006 (2006-07-20) paragraphs [0036]-[0102], fig. 1-25 | 1-4 |

☐ Further documents are listed in the continuation of Box C.     ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **22 June 2021** | **06 July 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2021/017057**

| Patent document cited in search report | | | Publication date (day/month/year) | Patent family member(s) | Publication date (day/month/year) |
|---|---|---|---|---|---|
| JP | 2019-139085 | A | 22 August 2019 | (Family: none) | |
| JP | 2010-103463 | A | 06 May 2010 | (Family: none) | |
| JP | 2009-519593 | A | 14 May 2009 | US 2009/0191469 A1<br>claim 1, paragraphs [0022]-[0058], fig. 1-3<br>FR 2894690 A1<br>WO 2007/068614 A1 | |
| JP | 2008-41740 | A | 21 February 2008 | (Family: none) | |
| JP | 2006-190900 | A | 20 July 2006 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011176162 A
- JP 2007273678 A
- JP 2011530823 A